# EUROPÄISCHE PATENTANMELDUNG

(11) **EP 1 306 506 A2**
(43) Veröffentlichungstag der Anmeldung: **02.05.2003**
(21) Anmeldenummer: 02022134.7
(22) Anmeldetag: 02.10.2002
(51) Int. Cl.: E05D 15/50, E05D 1/06, H05K 5/02

(54) **Steuerungsgehäuse mit Schwenkmechanismus im Deckel**

(30) Priorität: 11.10.2001 DE 20116631 U
(71) Anmelder: Hörmann KG Antriebstechnik, 33790 Halle i. Westfalen (DE)
(72) Erfinder: Simon, Thomas, 33803 Steinhagen (DE)
(74) Vertreter: Kastel, Stefan Dipl.-Phys.

(57) **Zusammenfassung**

Die Erfindung betrifft ein Steuerungsgehäuse (1) zur Aufnahme einer Steuerungseinrichtung für einen Torantrieb mit einem durch einen Grundkörper (2) gebildeten ersten Gehäuseteil und einem durch einen Deckel (3) zum Verschließen des Grundkörpers (2) gebildeten zweiten Gehäuseteil. Um eine leichtere Installation, Erweiterung, Wartung, Reparatur und/oder Einstellung von darin unterzubringenden bzw. untergebrachten Torantriebssteuerungselementen zu ermöglichen, wird vorgeschlagen, dass die beiden Gehäuseteile (2, 3) miteinander derart in Eingriff sind, dass der Deckel (3) wahlweise, insbesondere im wesentlichen senkrecht zur zu verschließenden Gehäuseöffnung (12), vom Grundkörper (2) abnehmbar ist oder um eine Drehachse geführt am Grundkörper (2) verbleibend auf- und zuklappbar ist.

## Beschreibung

Die Erfindung betrifft ein Steuerungsgehäuse zur Aufnahme einer Steuerungseinrichtung für einen Torantrieb mit einem durch einen Grundkörper gebildeten ersten Gehäuseteil und einem durch einen Deckel zum Verschließen des Grundkörpers gebildeten zweiten Gehäuseteil.

Die Anforderungen an Torantriebe sind in jüngster Zeit gestiegen. Der anzutreibende Torflügel soll nicht nur auf Knopfdruck automatisch geöffnet und/oder geschlossen werden, es gilt auch eine Reihe von Sicherheitsmaßnahmen zu erfüllen, um Gefahren durch den bewegten Torflügel ausschließen zu können. Hierzu weisen bekannte Torantriebe mehr oder weniger aufwendige, auf einer oder mehreren Platinen implantierte Steuerungen auf. Je nach Einsatzort sind die Tore und damit auch die im Nahbereich des Torantriebs anzuordnenden Steuerungen Umwelteinflüssen ausgesetzt, die der Elektronik schaden könnten. Aus diesem Grunde sind die Steuerungsplatinen bekannter auf dem Markt erhältlicher Torantriebe in Steuerungsgehäusen der eingangs genannten Art untergebracht, die mit ihrem Gehäusegrundkörper im Nahbereich des Tores, beispielsweise an einer die Toröffnung berandenden Wand befestigt sind. Die bekannten Gehäuse sind meist quaderförmig aus Kunststoff gebildet. Der Deckel ist zum Abschließen des Gehäuseinneren gegen Umwelteinflüsse vorgesehen. Er wird nach Installation der Platine(n) oder sonstiger elektrischer und/oder elektronischer Bauteile auf dem Grundkörper aufgesetzt und mit Befestigungsschrauben lösbar, vorzugsweise auch gegen Feuchtigkeit abdichtend, befestigt. Zur Wartung, Reparatur, Erweiterung oder Einstellung löst der Monteur die Befestigungsschrauben und hebt den Deckel ab, um zu der Platine zu gelangen.

Aufgabe der Erfindung ist es, ein Steuerungsgehäuse der eingangs genannten Art zu schaffen, das eine leichtere Installation, Erweiterung, Wartung, Reparatur und/oder Einstellung von darin unterzubringenden bzw. untergebrachten Torantriebssteuerungselementen ermöglicht.

Diese Aufgabe wird dadurch gelöst, dass die beiden Gehäuseteile miteinander derart in Eingriff sind, dass der Deckel wahlweise, insbesondere im wesentlichen senkrecht zur zu verschließenden Gehäuseöffnung, vom Grundkörper abnehmbar ist oder um eine Drehachse geführt am Grundkörper verbleibend auf- und zuklappbar ist.

Auf diese Weise hat der Monteur je nach örtlichen Gegebenheiten die Wahl, ob er für einen optimalen Zugang zu der Steuerung den Deckel wie im Stand der Technik üblich durch Abheben ganz entfernt oder ob er den Deckel einfach nur aufklappt. Letzteres kann verschiedene Arbeiten erheblich erleichtern, da der Monteur nach dem Aufklappen den Deckel nicht festhalten oder ablegen muss. Dies ist insbesondere im Hinblick darauf vorteilhaft, dass solche Gehäuse meist an schwer zugänglichen, oft nur mit Leitern erreichbaren Orten angebracht sind.

Vorteilhafte Ausgestaltungen der Erfindung sind Gegenstand der Unteransprüche.

Wenn das Steuerungsgehäuse mit einem mehrseitigen Schwenkmechanismus zum wahlweisen Aufklappen des Deckels auf eine von mehreren Seiten versehen ist, so ist das Gehäuse auch dann noch aufklappbar, wenn ein Aufklappen in eine bestimmte Richtung aufgrund der örtlichen Gegebenheiten - beispielsweise Anordnung der Steuerung in einer Raumecke - nicht möglich oder unhandlich wäre.

Die Erfindung ist insbesondere zur Aufnahme einer Steuerung für Industrietorsysteme gedacht und geeignet. Bei solchen Industrietorsystemen gibt es oft rechts oder links relativ wenig Platz, so dass der Deckel entweder nach links oder nach rechts schwenkbar sein soll. Dies wird durch den mehrseitigen Schwenkmechanismus erzielt. Für die Montage der Steuerung soll der Deckel komplett abbaubar sein, damit die Montage bequem vonstatten gehen kann.

Eine Arretiereinrichtung zum Sichern des Deckels in einer aufgeklappten Stellung gegen Herunterfallen und/oder zum Arretieren des Deckels in der aufgeklappten Stellung erleichtert die Handhabung weiter. Eine solche Arretiereinrichtung könnte verschieden aufgebaut sein. In einfachster Ausbildung ist bspw. ein Endanschlag vorgesehen, gegen den der Deckel aufgeklappt wird. Dies verhindert einerseits ein Herabfallen des Deckels von dem Gehäusegrundkörper, andererseits könnte der Deckel einfach durch Schwerkraft an dem Anschlag anliegend arretiert werden.

Eine vorteilhafte Ausgestaltung der Erfindung, die ohne gesondertes Scharnier auskommt zeichnet sich aus durch:
- eine Eingriffseinrichtung an einem der beiden Gehäuseteile, welche beim Aufsetzen des Deckels in eine erste, die Relativbewegung von Deckel und Grundkörper beim Aufsetzen und Abnehmen des Deckels im wesentlichen geradlinig führende Führungseinrichtung an dem anderen Gehäuseteil einführbar und beim Abnehmen daraus entfernbar ist, und
- eine sich vom Nahbereich der ersten Führungseinrichtung erstreckende zweite Führungseinrichtung, welche bei einem Verschwenken des aufgesetzten Deckels von einem Abschnitt der Eingriffseinrichtung zum Führen der Verschwenkbewegung erfassbar ist.

Die beiden Führungseinrichtungen könnten beispielsweise durch eine Kurvenbahn für einen von dem einen der beiden Gehäuseteile vorstehenden Eingreifsvorsprung an dem anderen der beiden Gehäuseteile gebildet sein. Eine solche Bahn ermöglicht zunächst ein normales Aufsetzen und ggfs. auch Befestigen des Deckels. Ein die zweite Führungseinrichtung bildender Abschnitt der Kurvenbahn ermöglicht weiter aber auch eine Führung einer Schwenköffnung des dann am Grundkörper verbleibenden Deckels. In bevorzugter Ausgestaltung weist die Eingriffseinrichtung einen etwa stiftförmigen Ansatz an dem Deckel auf, der an seinem freien Ende mit einem Vorsprung versehen ist. Die erste Führungseinrichtung ist bevorzugt durch eine komplementär zu dem Ansatz ausgebildete und angeordnete Eingreiföffnung in Form einer Aussparung oder Nut an dem Grundkörper gebildet. Diese Führungsaussparung ist weiter bevorzugt an einer Außenwand von einer die zu verschließende Gehäuseöffnung berandenden Rand ausgehend im wesentlichen geradlinig von der Gehäuseöffnung weg führend ausgebildet. Die zweite Führungseinrichtung ist weiter bevorzugt durch ein durch den Vorsprung hintergreifbares Führungselement mit einer im wesentlichen bogenförmig verlaufenden Führungsfläche zum Führen dieses Vorsprungs gebildet. Diese durch den vorzugsweise hakenähnlichen (End-)Vorsprung des Ansatzes ergreifbare Führungsfläche erstreckt sich vorzugsweise von einem entsprechenden (End-)Bereich der Aussparung ausgehend bogenförmig in das Innere des Gehäuses hinein und krümmt sich dort wieder zurück in Richtung auf die durch den Deckel zu verschließende Gehäuseöffnung. Beispielsweise erstreckt sich die Führungsfläche von dem Endbereich der Aussparung, der deren Einführende, also bspw. deren am Rand des Grundkörpers im Bereich der Gehäuseöffnung offenen Ende, gegenüberliegt.

Zum Bilden des mehrseitigen Schwenkmechanismus' ist weiter vorzugsweise an mehreren der die Gehäuseöffnung deckel- und grundkörperseitig umgebenden Rändern wenigstens ein durch eine Eingriffseinrichtung und durch die beiden Führungseinrichtungen gebildetes Ensemble vorgesehen, um den Deckel wahlweise um eine von mehreren - vorzugsweise parallel zu den Rändern im Nahbereich derselben - verlaufende Drehachsen aufklappen zu können. Bei etwa rechteckigem Grundriss des Gehäuses ist dabei bevorzugt, dass jeweils im Nahbereich jeder Ecke des rechteckförmigen Grundrisses je eines dieser Ensembles vorhanden ist, um je eine Ecke des Deckels bei der Aufklappbewegung an dem Grundkörper zu führen und zu halten. Weiter vorzugsweise sind die Drehachsen dabei parallel und nahe jeweils zweier gegenüberliegender Ränder, beispielsweise nahe und parallel jeweils zu den langen oder kurzen Rändern bei rechteckförmiger Gehäuseöffnung, angeordnet. Um nun zu verhindern, dass der Deckel bei Umklappen um eine erste Drehachse an den Halte- und Führungselementen, die zum Umklappen um eine zweite Drehachse vorgesehen sind, festgesetzt wird, könnte vorgesehen sein, dass jede erste Führungseinrichtung, d.h. z.B. jede Aussparung, insbesondere an ihrem Einführende, eine in Richtung auf die erste Drehachse gegenüber übrigen Führungsflächen der ersten Führungseinrichtung zurückspringend ausgebildete Begrenzungsteilfläche für die Anlage eines entsprechenden Teilbereichs, beispielsweise eines Hals- oder Schaftbereichs, der Eingriffseinrichtung hat und/oder dass die zum Drehen um die zweite Drehachse bestimmte Eingriffseinrichtung, also bspw. der der zweiten Drehachse zugeordnete stiftförmige Ansatz, an seiner zu der ersten Drehachse weisenden Fläche konkav ausgebildet ist.

Im Prinzip reicht das zuvor erwähnte Ensemble von Eingriffs- und Führungseinrichtungen zum Führen der Aufklappbewegung und zum Halten des Deckels an dem Grundkörper aus. In bevorzugter Ausgestaltung ist zur Erleichterung der Aufklappbewegung aber zusätzlich oder alternativ zu diesem Ensemble ein Lagerglied an einem der beiden Gehäuseteile vorgesehen, das beim Aufsetzen des Deckels in eine Drehpunktaufnahme an dem anderen Gehäuseteil einführbar ist, um so eine Lagereinrichtung zum Definieren der Drehachse zu bilden. Weiter vorzugsweise ist dabei jedem Ensemble jeweils wenigstens eine dieser Lagereinrichtungen zugeordnet. Dies hat den Vorteil, dass die Drehpunktaufnahme in Abhebe- und Einführrichtung beispielsweise auch vollkommen offen sein kann, so dass Aufsetzen und Abheben- im Gegensatz beispielsweise zu einer zusammenklippsbaren Lagereinrichtung - nicht behindert wird. Die Aufnahme kann in ihrer geschlossenen Hälfte das Lagerglied z.B. eng umfassen oder ergreifen, um so die Drehachse exakt zu definieren. Ein Herausfallen aus der halbseitig offenen Drehpunktaufnahme bei verschwenktem Deckel wird durch das Zusammenwirken der zweiten Führungseinrichtung mit der Eingriffseinrichtung verhindert, wobei letztere sich aber bei exakter Drehachsenbestimmung durch die Lagereinrichtung im Laufe der Schwenkbewegung nicht unbedingt erfassen müssen. Durch Aneinanderreiben von Eingriffs- und zweiter Führungseinrichtung bedingte Nachteile werden dadurch vermieden. Vorzugsweise ist an jeder Ecke der Öffnungsberandung eine Lagereinrichtung vorgesehen, um so die Deckelecken an dem Grundkörper zu halten. Weiter kann auch vorgesehen sein, dass die Lagereinrichtung beim Zusammenfügen doch (z.B. leicht) zusammengeklippst werden muss, was Vorteile bei der Montage des Deckels zum Beispiel über Kopf oder in vertikaler Lage hat. Eine einfache Ausführung des Lagerglieds ist dadurch geschaffen, dass das Lagerglied ein neben der Eingriffseinrichtung an einem Rand des Deckels ausgebildetes teilweise rotationssymmetrisch um eine parallel zu dem Rand verlaufende, die Drehachse definierende Achse ausgebildetes Zylinder-- oder Kugelsegment ist.

Von besonderem Vorteil ist, dass bei der erfindungsgemäßen Ausbildung sämtliche die bei dem Aufsetzen und Schwenken zum Führen der Relativbewegung aneinander angreifenden Einrichtungen, Ansätze und Glieder der Gehäuseteile jeweils integral mit einem der beiden Gehäuseteile ausgebildet sein können. Es werden dann (bis auf eventuelle Befestiger wie Befestigungsschrauben oder dergleichen zum festen Verschließen und/oder Abdichten des Deckels) keine Zusatzteile bei Herstellung oder Montage des erfindungsgemäßen Steuerungsgehäuses benötigt. So können die Eingriffseinrichtung, das Lagerglied, die Drehpunktaufnahme und die erste sowie die zweite Führungseinrichtung jeweils integrale Bestandteile eines der beiden Gehäuseteile sein. Die Gehäuseteile sind vorzugsweise mit diesen Einrichtungen bzw. Gliedern im Spritzgussverfahren aus Kunststoff oder dergleichen in einem Stück gegossen.

Ein Ausführungsbeispiel der Erfindung wird nachfolgend anhand der beigefügten Zeichnung näher erläutert. Darin zeigt:
- Fig. 1: eine perspektivische, teilweise weggebrochene Ansicht auf ein aus einem Grundkörper und einem Deckel gebildetes Gehäuse für eine Torantriebssteuerung;
- Fig. 2: eine perspektivische Ansicht auf eine Ecke des Grundkörpers;
- Fig. 3: eine perspektivische Ansicht auf eine Ecke des Deckels;
- Fig. 4: eine geschnittene Seitenansicht auf das Gehäuse von Fig. 1 bei um ca. 3° gegenüber dem Grundkörper verschwenktem Deckel;
- Fig. 5: eine perspektivische Ansicht des mit "X" in Fig. 1 gekennzeichneten Eckbereichs des Gehäuses bei einem Schwenkwinkel zwischen Grundkörper und Deckel von 0°;
- Fig. 6: eine perspektivische Ansicht des mit "X" in Fig. 1 gekennzeichneten Eckbereichs des Gehäuses bei einem Schwenkwinkel zwischen Grundkörper und Deckel von 3°;
- Fig. 7: eine perspektivische Ansicht des mit "X" in Fig. 1 gekennzeichneten Eckbereichs des Gehäuses bei einem Schwenkwinkel zwischen Grundkörper und Deckel von 45°; und
- Fig. 8: eine perspektivische Ansicht des mit "X" in Fig. 1 gekennzeichneten Eckbereichs des Gehäuses bei einem Schwenkwinkel zwischen Grundkörper und Deckel von 90°.

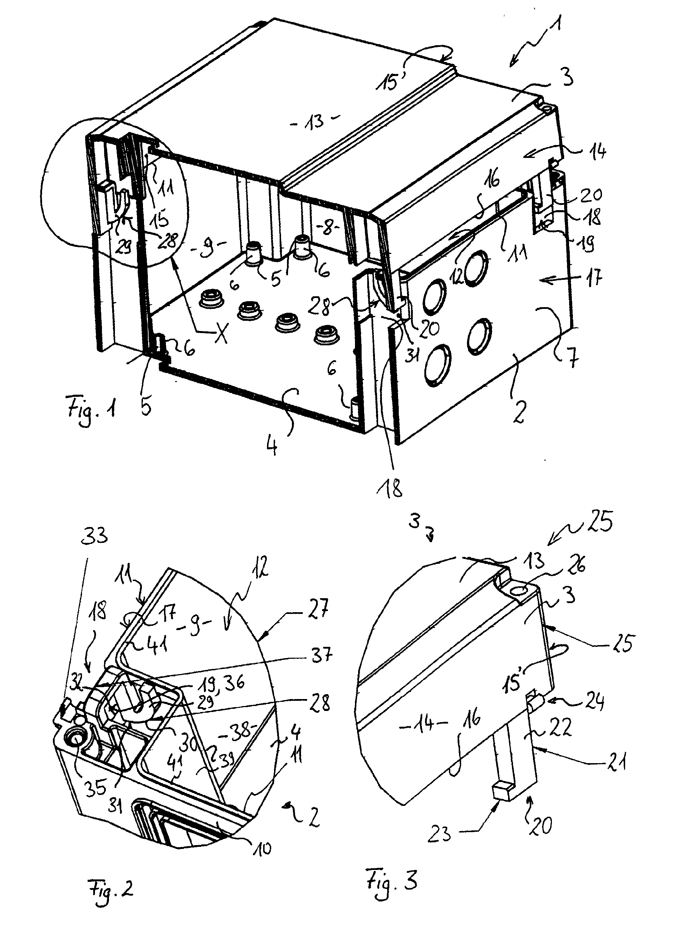

In Fig. 1 ist ein Gehäuse 1 zur Aufnahme elektronischer Bauteile (nicht dargestellt), insbesondere Platinen, einer Steuerung für einen Torantrieb (ebenfalls nicht dargestellt) gezeigt. Das Gehäuse 1 weist einen Grundkörper 2 und einen Deckel 3 auf.

Das Gehäuse 1 ist insgesamt im wesentlichen quaderförmig. Der Grundkörper 2 bildet den größten Teil des Gehäuses 1 und weist einen Boden 4 mit Bohrungen 5 und Hülsen 6 für die Aufnahme von nicht dargestellten Wandbefestigern wie Dübelschrauben sowie vier Grundkörperseitenwände 7, 8, 9 und 10 (siehe auch Fig. 2) auf. Die vier Grundkörperseitenwände 7-10 begrenzen mit ihren dem Boden 4 entgegengesetzten freien Rändern 11 eine etwa rechteckige Gehäuseöffnung 12, durch welche die elektronischen Bauteile eingebracht werden können und für Arbeiten zugänglich sind. Die Gehäuseöffnung 12 ist durch den Deckel 3 verschlossen.

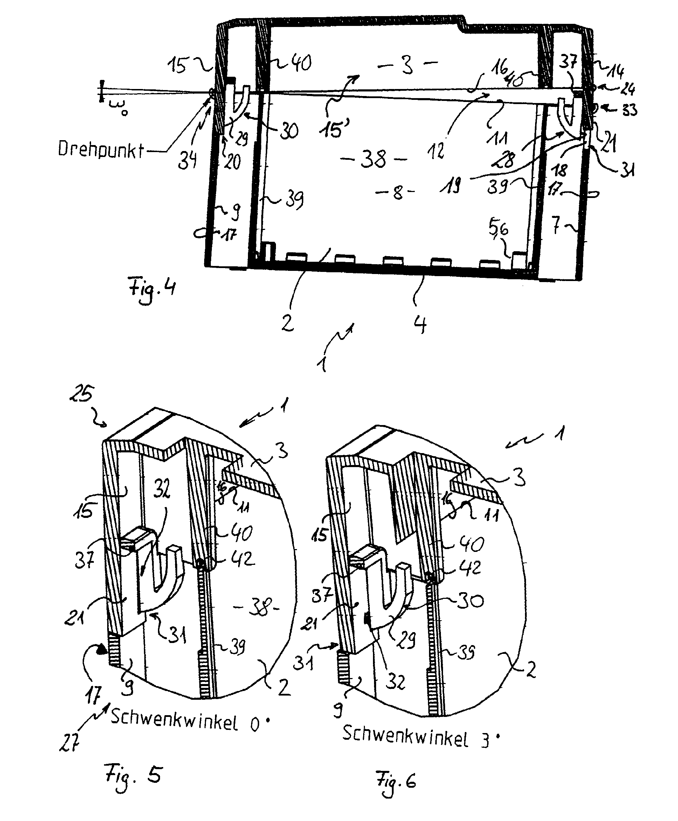

Der Deckel 3 weist eine Deckplatte 13 und ebenfalls vier Seitenwände auf, die im folgenden Deckelseitenwände 14, 15, 15' (siehe auch Fig. 4) genannt werden. Mit den freien Rändern 16 der Deckelseitenwände 14, 15, 15' wird der Deckel 3 mit den Rändern 11 der Grundkörperseitenwände 7-10 zum Verschließen der Gehäuseöffnung 12 in Anlage gebracht.

Wie in Fig. 1 dargestellt, weisen die Außenflächen 17 zweier gegenüberliegender Grundkörperseitenwände 7 und 9 sich von dem freien Rand 11 aus in etwa geradlinig weg von der Gehäuseöffnung (in Fig. 1 nach unten) erstreckende Aussparungen 18 auf. Flächenbereiche dieser Aussparungen 18 dienen als erste Führungseinrichtungen 19 zum Führen von an dem Deckel 3 in entsprechender Lage angeordneten Eingriffseinrichtungen 20.

Die Eingriffseinrichtungen 20 sind, wie am besten in Fig. 3 zu sehen, durch an den Rändern 16 der Deckelseitenwände 14, 15 integral mit dem Deckel 3 ausgebildete stiftförmige Ansätze 21 gebildet, die einen etwa rechteckiges Profil aufweisenden Halsbereich 22 und einen hakenartigen Vorsprung an dem freien Ende aufweisen, der im folgenden als Hacken 23 bezeichnet wird. Die Eingriffseinrichtungen 20 sind - wie die Aussparungen 18 an dem Grundkörper 2 - im Nahbereich der Eckkanten des Deckels 3 und zwar zu je zweien an der gleichen Deckelseitenwand 14 bzw. 15 ausgebildet. Neben der Eingriffseinrichtung 20 ist an dem Rand 16 der Deckelseitenwände 14, 15 noch ein Lagerglied 24 ebenfalls integral mit dem Deckel 3 ausgebildet. Das Lagerglied 24 hat einen weitgehend rotationssymmetrisch zu einer parallel zu dem Rand 16 verlaufenden, eine Drehachse definierenden Achse ausgebildeten walzensegmentförmigen Körper. Außerdem ist in jedem Eckbereich 25 des Deckels 3 eine Bohrung 26 zur Aufnahme von Schrauben (nicht dargestellt) vorgesehen, mittels welcher der Deckel 3 fest an dem Grundkörper 2 befestigbar ist.

Eine der vier vergleichbar gestalteten Eckbereiche 27 des Grundkörpers 2 ist in Fig. 2 dargestellt. Der Eckbereich 27 weist die Aussparung 18 und eine zweite Führungseinrichtung 28 auf. Diese umfasst ein Führungselement 29, das integral mit dem Grundkörper 2 ausgeführt ist und eine bogenförmige Führungsfläche 30 aufweist. Die in den Zeichnungen dargestellte Ausnehmung im Inneren des Führungselements ist herstellungstechnisch (spritztechnisch) bedingt; es soll dort bei der Herstellung keine Materialanhäufung stattfinden. Die Führungsfläche 30 erstreckt sich von einem dem Rand 11 entgegengerichtet liegenden Endbereich 31 der Aussparung 18 ausgehend bogenförmig nach innen und zurück zur Gehäuseöffnung 12 hin. Benachbart zu dem Führungselement 29 hat die Aussparung 18 einen tiefer in das Gehäuseinnere reichenden Bereich 32. Die Aussparung 18 dient zur Aufnahme der Eingriffseinrichtung 20, die bei einem Aufklappen des Deckels 3 mit ihrem Hacken 23 die bogenförmige Führungsfläche 30 hintergreift, wobei der tiefere Bereich 32 dabei den Halsbereich 22 aufnimmt. Weiterhin ist in jedem Eckbereich 27 neben der Aussparung 18 noch eine Drehpunktaufnahme 33 zur Aufnahme des Lagergliedes 24 vorgesehen. Die Drehpunktaufnahme 33 hat eine zylindermantelsegmentförmige Innenfläche zum Führen des Lagergliedes 24 und ist zum Deckel 3 hin zur Aufnahme und Entfernung desselben offen. Die Drehpunktaufnahme 33 bildet zusammen mit dem Lagerglied 24 eine Lagereinrichtung 34, die die Drehachse zum Aufklappen des Deckels 3 definiert.

Durch die gegenüberliegende Anordnung zweier Paare von Eingriffseinrichtungen 20, Führungseinrichtungen 19 und 28 und Lagereinrichtungen 34 an verschiedenen, hier gegenüberliegenden, Rändern 11, 16 der Seitenwände 7-10 und 14, 15 von Deckel 3 und Grundkörper 2 sind zwei Drehachsen geschaffen, um welche der Deckel 3 wahlweise zu der einen oder der anderen Seite hin aufgeklappt werden kann. Auf diese Weise ist durch die Anordnung der beiden Paare von Eingriffseinrichtungen 20, Führungseinrichtungen 19 und 28 und Lagereinrichtungen 34 ein mehrseitiger Schwenkmechanismus für den Deckel geschaffen.

Außerdem ist in dem Eckbereich 27 des Grundkörpers 2 noch eine Sacköffnung 35 zur Aufnahme eines Gewindeschaftes der zur Deckelbefestigung dienenden Schraube vorgesehen. Die einen Teil der Aussparung 18 bildende Außenfläche 36 des Führungselementes 29 dient zum Führen des Hackens 23 beim Aufsetzen des Deckels 3. Gegenüber dieser Außenfläche etwas ins Gehäuseinnere versetzt angeordnet überspannt ein Bogen 37 den tieferen, zur Aufnahme des Halsbereichs 22 des stiftförmigen Ansatzes 21 bestimmten Bereich 32 der Aussparung 18. Der Bogen 37, der im nahe dem Rand 11 parallel zu diesem angeordnet ist dient einerseits zur Führung des Halsbereichs 22 beim Aufsetzen des Deckels 3, ermöglicht andererseits aufgrund seiner ins Innere versetzten Lage eine Verschwenkung des Deckels 3 um eine auf der gegenüberliegenden Seite liegende Drehachse, ohne dass der Halsbereich 22 durch die Verdrehung festgesetzt werden würde, und dient drittens als Endanschlag bei einer Verdrehung des Deckels 3 um die durch die zugeordnete Lagereinrichtung 34 definierte diesseitige Drehachse.

Der Eckbereich 27 des Grundkörpers 2 ist von dem zur Aufnahme der Elektronik dienenden Gehäuseinnenraum 38 durch Trennwände 39 abgetrennt. Entsprechende Trennwände 40 gibt es in den Eckbereichen 25 des Deckels 3. Entlang des Seitenwandrandes 11 und im Eckbereich 27 am Rand der Trennwände 34 verläuft am Grundkörper 2 ein Randvorsprung 41 mit gegenüber den Wänden 7-10 und 38, 39 geringerer Dicke. Der Randvorsprung 41 greift bei geschlossenen Deckel 3 in eine entsprechend am Deckelrand 16 bzw. dem Rand der Deckeltrennwände 40 verlaufende Nut 42 nach Art von Nut und Feder ein.

Das Aufbringen und Abnehmen des Deckels 3 sowie die Funktion des Schwenkmechanismus wird im folgenden anhand der Darstellungen in den Fig. 1 und insbesondere den Fig. 4 bis 8 näher erläutert.

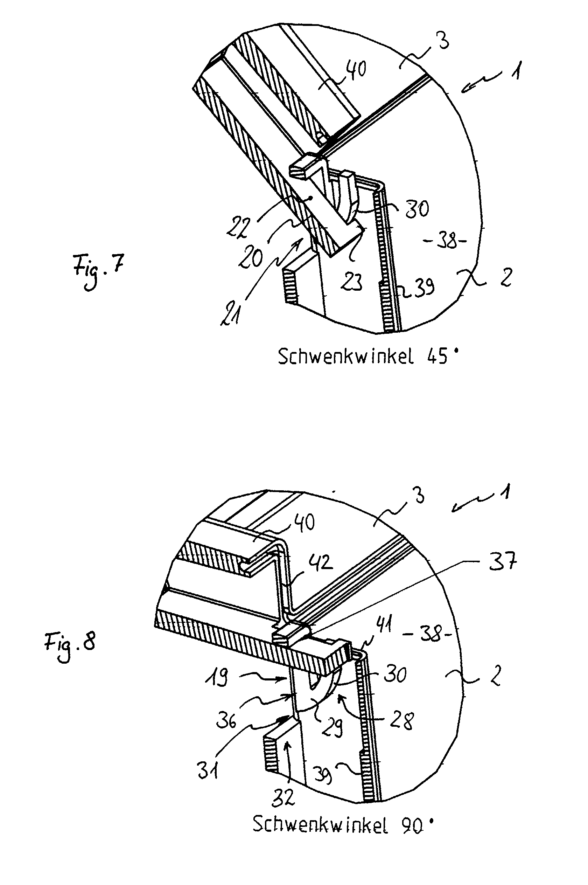

Beim Aufsetzen des Deckels 3 werden die Eingriffseinrichtungen 20 in die Einführenden der zum Rand 11 hin reichenden und daher dort offenen Aussparungen 18 eingeführt. Die Aussparungen 18 führen durch Anlage des Hackens 23 an der Außenfläche 36 des Führungselements 29 und durch Anlage des Halsbereichs 22 an senkrecht zur entsprechenden Gehäuseseitenwand verlaufenden Begrenzungsflächen der Aussparung 18 sowie dem Bogen 37 eine im wesentliche geradlinige Aufsetzbewegung, bis nahe der Schließstellung der Hacken 23 das dem Rand 11 gegenüberliegende Ende der Außenfläche 36 des Führungselements 29 erreicht, wo sich die Aussparung 18 nach innen hin öffnet und von wo aus sich die bogenförmige Führungsfläche 30 des Führungselementes 29 erstreckt. In dieser Stellung greift der Randvorsprung 39 in die Nut 40 ein, weswegen Verschiebungen trotz der dann fehlenden Anlage zwischen Hacken 23 und der ersten Führungseinrichtung 19, die hier im wesentlichen durch die Außenfläche 36 gebildet ist, vermieden werden. Die dann erreichte Schließstellung mit 0° Schwenkwinkel ist in Fig. 5 dargestellt.

Die Fig. 1, 4 und 6 zeigen dagegen eine anfängliche Verschwenkung von 3°, die aufgrund der nach innen versetzte Lage der Angriffsfläche des Bogens 37 trotz Eingriff der Eingriffseinrichtung 20 in die Aussparung 18 ohne Verkeilen möglich ist. Bei etwa 3° Relativverschwenkung beginnt der Hacken 23 die bogenförmige Führungsfläche 30 zu hintergreifen.

Fig. 7 zeigt eine Zwischenstellung bei etwa 45° Schwenkwinkel. Bei etwa 90° Schwenkwinkel schlägt, wie in Fig. 8 gezeigt, ein Abschnitt der Eingreifseinrichtung 20, hier ein Abschnitt des Halsbereichs 22, an einen Endanschlag, hier gebildet durch den Bogen 37, an. Der Bogen 37 ist durch seine ins Gehäuseinnere hinein versetzte Lage auch beabstandet von der die Drehachse (in Fig. 4 Drehpunkt genannt) definierenden zugeordneten Lagereinrichtung 34 und somit in der Lage das für den Anschlag notwendige Gegendrehmoment auf die Eingriffseinrichtung 20 auszuüben. Bei entsprechender Ausrichtung wird der Deckel 3 in dieser Lage durch seine eigenes Gewicht gehalten, wodurch der durch den Bogen 37 gebildete Endanschlag als Arretiereinrichtung zum Arretieren des Deckels 3 in seiner aufgeklappten Stellung dient.

### Bezugszeichenliste

- 1: Gehäuse
- 2: Grundkörper
- 3: Deckel
- 4: Boden
- 5: Bohrungen
- 6: Hülsen
- 7: Grundkörperseitenwand
- 8: Grundkörperseitenwand
- 9: Grundkörperseitenwand
- 10: Grundkörperseitenwand
- 11: Ränder der Grundkörperseitenwände
- 12: Gehäuseöffnung
- 13: Deckplatte
- 14: Deckelseitenwand
- 15, 15': Deckelseitenwand
- 16: Ränder der Deckelseitenwände
- 17: Außenfläche
- 18: Aussparung
- 19: erste Führungseinrichtung
- 20: Eingriffseinrichtung
- 21: stiftförmiger Ansatz

- 22: Halsbereich
- 23: Hacken
- 24: Lagerglied
- 25: Eckbereich des Deckels
- 26: Bohrung
- 27: Eckbereich des Grundkörpers
- 28: zweite Führungseinrichtung
- 29: Führungselement
- 30: bogenförmige Führungsfläche
- 31: Endbereich der Aussparung
- 32: tieferer Bereich der Aussparung
- 33: Drehpunktaufnahme
- 34: Lagereinrichtung
- 35: Sacköffnung
- 36: Außenfläche des Führungselements
- 37: Bogen (Endanschlag)
- 38: Gehäuseinnenraum
- 39: Trennwände
- 40: Trennwände
- 41: Randvorsprung
- 42: Nut

## Patentansprüche

1. Steuerungsgehäuse (1) zur Aufnahme einer Steuerungseinrichtung für einen Torantrieb mit:
• einem durch einen Grundkörper (2) gebildeten ersten Gehäuseteil und
• einem durch einen Deckel (3) zum Verschließen des Grundkörpers (2) gebildeten zweiten Gehäuseteil,
**dadurch gekennzeichnet,**
**dass** die beiden Gehäuseteile (2, 3) miteinander derart in Eingriff sind, dass der Deckel (3) wahlweise, insbesondere im wesentlichen senkrecht zur zu verschließenden Gehäuseöffnung (12), vom Grundkörper (2) abnehmbar ist oder um eine Drehachse geführt am Grundkörper (2) verbleibend auf- und zuklappbar ist.

2. Steuerungsgehäuse nach Anspruch 1,
**gekennzeichnet durch**
einen mehrseitigen Schwenkmechanismus (20, 19, 28, 34) zum wahlweisen Aufklappen des Deckels (3) auf eine von mehreren Seiten.

3. Steuerungsgehäuse nach einem der Ansprüche 1 oder 2,
**gekennzeichnet durch**
eine insbesondere **durch** einen Endanschlag (37) des Schwenkmechanismus (20, 19, 28, 34) gebildete Arretiereinrichtung zum Sichern des Deckels (3) in einer aufgeklappten Stellung gegen Herunterfallen und/oder Zufallen.

4. Steuerungsgehäuse nach einem der voranstehenden Ansprüche,
**gekennzeichnet durch**
• eine Eingriffseinrichtung (20) an einem (3) der beiden Gehäuseteile (2, 3), welche beim Aufsetzen des Deckels (3) mit einer ersten, die Relativbewegung von Deckel (3) und Grundkörper (2) beim Aufsetzen und Abnehmen des Deckels (3) im wesentlichen geradlinig führenden Führungseinrichtung (19) an dem anderen Gehäuseteil (3) in Eingriff bringbar und beim Abnehmen davon lösbar ist, und
• eine, sich vorzugsweise vom Nahbereich der ersten Führungseinrichtung (19) erstreckende, zweite Führungseinrichtung (28), welche bei einem Verschwenken des aufgesetzten Deckels (3) von der Eingriffseinrichtung (20) zum Führen der Verschwenkbewegung erfassbar ist.

5. Steuerungsgehäuse nach Anspruch 4,
**dadurch gekennzeichnet,**
**dass** die Eingriffseinrichtung (20) einen etwa stiftförmigen Ansatz (21) an dem Deckel (3) aufweist, der - insbesondere an seinem freien Ende - mit einer hakenähnlichen Ausbildung und/oder einem Vorsprung (23) versehen ist,
**dass** die erste Führungseinrichtung (19) eine passend zu dem Ansatz (21) ausgebildete und angeordnete Aussparung (18) an dem Grundkörper (2), vorzugsweise in einer Außenfläche (17) des Grundkörpers (2), aufweist, und
**dass** die zweite Führungseinrichtung (28) ein durch den Vorsprung (23) hintergreifbares Führungselement (29) mit einer im wesentlichen bogenförmig verlaufenden Führungsfläche (30) zum Führen dieses Vorsprungs (23) aufweist, welche Führungsfläche (30) - insbesondere von einem gegenüberliegend eines Einführendes gelegenen Endbereich (31) der Aussparung (18) ausgehend - sich bogenförmig in das Innere des Gehäuses (1) hinein und in Richtung auf die Gehäuseöfnung (12) erstreckt.

6. Steuerungsgehäuse nach Anspruch 2 und einem der Ansprüche 4 oder 5,
**dadurch gekennzeichnet,**
**dass** der mehrseitige Schwenkmechanismus (20, 19, 28, 34) bei etwa rechteckigem Grundriss des Gehäuses (1) gebildet ist durch Anordnung jeweils wenigstens einer Eingriffseinrichtung (20), wenigstens einer ersten (19) und wenigstens einer zweiten (28) Führungseinrichtung an zwei oder mehreren der die Gehäuseöffnung (12) berandenden Gehäuseteilrändern (11, 16), vorzugsweise jeweils im Nahbereich (25, 27) jeder Ecke des rechteckförmigen Grundrisses.

7. Steuerungsgehäuse nach einem der voranstehenden Ansprüche,
**gekennzeichnet durch**
ein Lagerglied (24) an einem (3) der beiden Gehäuseteile (2, 3), das beim Aufsetzen des Deckels (3) in eine Drehpunktaufnahme (33) an dem anderen Gehäuseteil (2) einführbar ist, um so eine Lagereinrichtung (34) zum Definieren der Drehachse zu bilden.

8. Steuerungsgehäuse nach Anspruch 6 und Anspruch 7,
**dadurch gekennzeichnet,**
**dass** jedem aus einer Eingriffseinrichtung (20) und den zugeordneten Führungseinrichtungen (19, 28) gebildetem Ensemble je wenigstens eine Lagereinrichtung (34) zugeordnet ist, wobei vorzugsweise in jedem Eckbereich (25, 27) der Öffnungsberandung (11, 16) eine Lagereinrichtung (34) vorgesehen ist.

9. Steuerungsgehäuse nach einem der voranstehenden Ansprüche,
**dadurch gekennzeichnet,**
**dass** das Lagerglied (24) ein neben der Eingriffseinrichtung (20) an einem Rand (16) des Deckels (3) ausgebildetes teilweise rotationssymmetrisch um eine parallel zu dem Rand verlaufende, die Drehachse definierende Achse ausgebildetes walzen-, zylinder- oder kugelsegmentförmiges Teil aufweist.

10. Steuerungsgehäuse nach einem der voranstehenden Ansprüche,
**dadurch gekennzeichnet,**
**dass** die bei dem Aufsetzen und Schwenken zum Führen der Relativbewegung aneinander angreifenden Einrichtungen, Ansätze und Glieder (18, 19, 20, 21, 22, 23, 24, 28, 29, 30, 33, 37) der Gehäuseteile (2, 3) jeweils integral mit einem der beiden, insbesondere im Spritzgussverfahren aus Kunststoff oder dergleichen hergestellten, Gehäuseteile (2, 3) ausgebildet sind.
